Europäisches Patentamt

European Patent Office

Office européen des brevets

(11) Publication number: **0 181 624**
**B1**

(12) **EUROPEAN PATENT SPECIFICATION**

(45) Date of publication of patent specification: **06.12.89**

(51) Int. Cl.⁴: **C 23 C 16/44,** C 30 B 25/12,
C 30 B 25/14

(21) Application number: **85114268.7**

(22) Date of filing: **11.01.82**

(60) Publication number of the earlier application in
accordance with Art. 76 EPC: **0 056 326**

(54) Coating of semiconductor wafers and apparatus therefor.

(30) Priority: **14.01.81 CA 368517**

(43) Date of publication of application:
**21.05.86 Bulletin 86/21**

(45) Publication of the grant of the patent:
**06.12.89 Bulletin 89/49**

(84) Designated Contracting States:
**CH DE FR GB LI NL SE**

(56) References cited:
**US-A-4 096 822**
**US-A-4 098 923**
**US-A-4 108 106**
**US-A-4 220 116**

(73) Proprietor: **NORTHERN TELECOM LIMITED**
**P.O. Box 3511 Station C**
**Ottawa Ontario, KIY 4H7 (CA)**

(72) Inventor: **Jenkins, George Miles**
**R.R. No. 2, Dunrobin**
**Ontario, K0A 1TO (CA)**

(74) Representative: **Crawford, Andrew Birkby et al**
**A.A. THORNTON & CO. Northumberland House**
**303-306 High Holborn**
**London WC1V 7LE (GB)**

Courier Press, Leamington Spa, England.

# Description

This invention relates to the coating of semiconductor wafers, in particular silicon wafers.

During manufacture of semiconductor devices, semiconductor wafers, particularly silicon wafers, are coated with an oxide layer, or other layer, such as doped or undoped polycrystalline silicon. Typically the oxide is silicon dioxide and may be doped, for example with phosphorus. The wafers are mounted in boats which are supported in furnaces and suitable gases fed to the boats, with the resulting formation or growing of the coatings. More than one layer or coating may be formed, for example a first layer of oxide and then a layer of polysilicon. Also an initial layer may have been produced by some other process.

One conventional form of boat comprises a plurality of glass (quartz) rods attached at each end to the peripheries of two semicircular end plates to form a "cage". A rail along each side at the top of the plates and a rail at the center bottom are slotted to provide spaced location for the wafers. A top or cover of glass (quartz) fits over the boat, the top being semi-cylindrical. A rectangular "box" made from quartz plates surrounds and supports the "cage" and is welded to it.

A conventional boat is, in one example, about 29 1/2" ($75 \times 10^{-2}$m) long, one boat being positioned in a furnace at a time. The boat is supported by the two parallel plates which form the sides of the box and two glass tube manifolds pass along between the side plates, under the boat. A longitudinal slit extends in each manifold for a distance corresponding to the length of the boat. A problem with such glass tube manifolds is that of expense, the longitudinal slit being particularly expensive to produce. A further problem is that growth rate, and therefore the thickness of the coating, varies along the boat. In particular the growth rate is low at the centre of the boat and increases towards each end, although there may be a fall off or reduction at the ends.

It is an object of the present invention to achieve a more uniform, consistent, growth rate and an increase in growth rate with a reduced variation in thickness.

In one aspect, the present invention provides apparatus for producing coatings on semiconductor wafers, comprising:

a boat for carrying said wafers, said boat comprising:

an elongated, transversely curved bottom member;

means for supporting wafers in said bottom member, and

openings formed in said bottom member to enable gases to flow into said bottom member; and

a manifold positioned below said bottom member, said manifold comprising an elongated glass tube having at least one inlet for receiving gases for coating said semiconductor wafers, a plurality of circular apertures which are equal in size and formed in a top surface of said tube, said apertures being spaced from one another along the length of said tube, said spacing being varied in a predetermined manner.

In a further aspect the invention provides a process for the production of coatings on semiconductor wafers, including mounting the wafers in boats and supporting the boats in a furnace; feeding a gas to at least one manifold extending beneath the boats; feeding gas from the manifold through aperture means disposed along the manifold, characterised by the aperture means comprising a plurality of spaced circular apertures which are equal in size, the spacing of the apertures being varied in a predetermined manner, the gas flowing up through the boats.

The invention will be readily understood by the following description, by way of example, particularly relating to forming oxide coatings on silicon wafers, in conjunction with the accompanying drawings, in which:—

Figure 1 is a top plan view of a boat;

Figure 2 is a cross-section on the line 2—2 of Figure 1;

Figures 3 and 4 are side and top plan views respectively of boats assembled to the support and manifold system in one configuration;

Figure 5 is a cross-section, similar to that of Figure 2, of a boat and cover on support tubes and with manifolds in a furnace;

Figure 6 is a cross-section, similar to that of Figure 5, of an alternative configuration, the boats not having covers;

Figure 7 is a top plan view of a manifold with gas feeds at both ends;

Figure 8 is a top plan view of a manifold with gas fed to one end only.

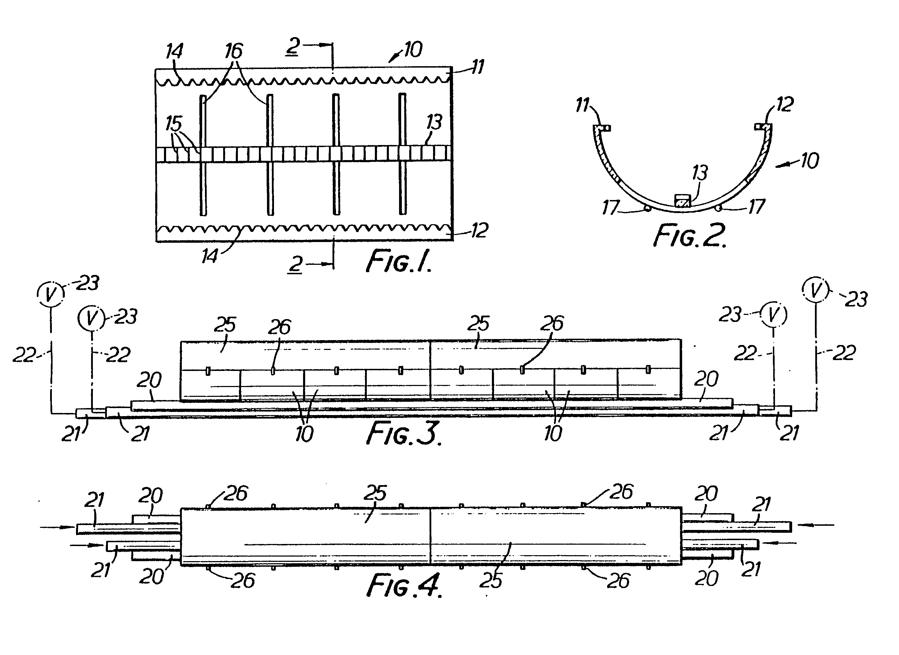

As seen in Figures 1 and 2, a boat 10 comprises a semi-cylindrical member of glass—quartz—with top rails 11 and 12 along the top edges and a bottom rail 13 on the center at the bottom. The top rails are slotted, at 14, and the bottom rail is similarly slotted, at 15. The slots 14 and 15 position and support wafers in the boat. Transverse slots 16 are made in the semi-cylindrical member. Attached to the exterior of the boat, near the bottom, spaced on either side of the longitudinal axis, are two small rods 17, the purpose of which will be explained later.

Figures 3 and 4 illustrate a typical arrangement using boats. The boats are supported on two tubes 20, and tubular manifolds 21 are positioned beneath the boats. Gases are fed to the manifolds at both ends indicated by the chain dotted lines 22, the flow rates controlled by valves 23. In the example the boats are of a length that eight boats are loaded, end-to-end. Covers 25 rest on top of the boats, the covers being semi-cylindrical members of glass—quartz. The covers are of a length to fit over four boats, but can be of different lengths, for example a cover for each boat. The covers are located by small tabs 26 attached to the bottom edges of the covers. The manifolds 21, and support tubes 20, are glass.

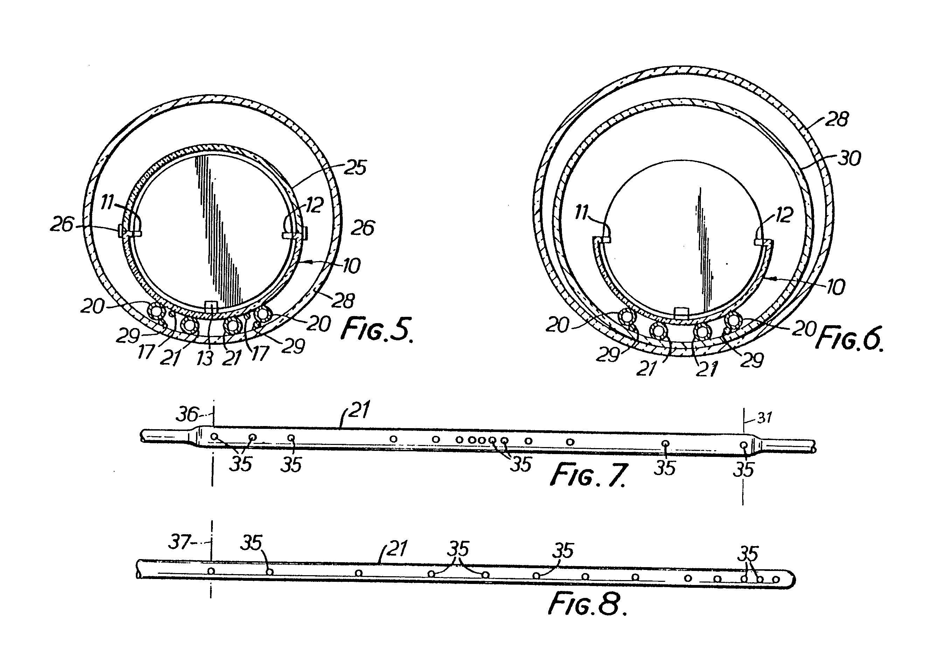

Figure 5 illustrates, in cross-section, the arrangement of boats 10, covers 25, support tubes 20 and manifolds 21 in a furnace tube 28. The manifolds 21 are first slid in and connected to the gas supply lines. This positions the manifolds on the bottom of the furnace tube 28. The support tubes 20 are connected at each end by a transverse member and the boats are loaded on to the support tubes, the boats filled with wafers. The covers 25 are assembled to the boats and then the whole assembly of support tubes, boats and covers slid into the furnace tube. The transverse members connecting the support tubes are arched to clear the manifolds. The rods 17 are positioned between the tubes 20, to avoid the possibility of rotation of the boats. However, the rods 17 are not essential and can be omitted.

To correctly position the boats, glass rods 29 can be attached to the support tubes 20, the rods resting on the base of the furnace tube 28.

In an alternative arrangement, illustrated in Figure 6, the covers 25 are omitted and the boats, with support tubes and manifolds assembled within a quartz liner, which in turn is within the furnace tube. Thus, in Figure 6, items common with Figure 5 are given the same reference numbers. The liner is indicated at 30. The liner rests at the bottom on the bottom of the furnace tube and the support tubes 20 and manifolds 21 rest on the bottom on the liner. Rods 29 can be provided as previously.

The use of the liner, 30, as in Figure 6, provides various advantages. The liner avoids the necessity of the occasional removal of the furnace tube for cleaning, thus avoiding the breaking and remaking vacuum connections and consequential testing for leaks. The use of covers is avoided, thus reducing costs. While vertical positioning of the boats may be more critical without covers this is readily obtained. Also, some slight non-uniformity of the coating at the peripheral edges of the wafers can often be accepted as usable devices are often not produced within about 1/4" (6.4 mm) or so of the periphery. A typical size of the liner is 140 mm internal diameter and 146 mm external diameter.

Figure 7 illustrates one form of manifold 21, in which gases are fed to both ends. Apertures 35 are circular holes which are equal in size and which are cut in the top surface of the manifold and their spacing along the length which is below the boats, between lines 36 and 31, is varied along this length.

The dimensions and spacing of slots 14, 15 and 16 and the apertures 35, and other details, will depend upon various variables, including wafer diameter. As an example, the following relates the various parameters for 100 mm diameter wafers. The conventional system uses a holder which is 29" (737 mm) long, and this length is largely determined by the so-called "flat length" of the furnace, the length over which the temperature is constant and consistent.

In the example of Figures 1, 2 and 5, the internal diameter of the holder, base 10 and cover 25, is 105 mm, and the outside diameter 110 mm. The length of the base or boat, 10 is about 5" (127 mm). The spacing of slots 14 and 15 is 3/16" (4.8 mm). Slots 16 are 2.5 mm wide and extend up to about 1" (25.4 mm) from the top edges of the rails 11 and 12. Four slots 16 are provided, evenly spaced from each other and the ends of the boat. The distance the bottom of the wafer is spaced from the bottom of the boat is important as this can effect the coating thickness at the edge of the wafer which is at the bottom. The rail 13 is made of such a height that the bottom surfaces of the slots 15 is approximately 5 mm above the surface of the boat.

The tubes 20 are 19 mm external diameter and 14 mm internal diameter. The manifolds 21 are 14 mm external diameter and 12 mm internal diameter in the apertured length and 12 mm O/D, 8 mm O/D at the ends. The manifolds are spaced about 1" (25.4 mm) apart symmetrically about the longitudinal axis, and the tubes 20 about 2" (50 mm) apart. The internal diameter of the furnace tube 28 is 150 mm. The spacing, or positioning of the apertures 35 in the manifold 21, is, for example, as follows, starting at line 36 at the left in Figure 7, with the position at line 36 as zero:— 0,1—1/2", 5-1/2", 10", 13", 13-1/2", 14", 14-1/2", 15", 16", 17", 23", and 29" (corresponding to spacings measured in metres $\times 10^{-2}$:— 0, 4, 14, 25, 33, 34, 36, 37, 38, 41, 43, 58 and 74), the 29" ($74 \times 10^{-2}$m) position being at the line 31 to the right in Figure 7.

The manifolds 21, instead of being fed from both ends, as is conventional, can be fed from one end only. Such a manifold is illustrated in Figure 8. This is particularly convenient in that the gas flow controls are considerably simpler. The spacing of the apertures 35 will be different and starting at a line 37, at the left in Figure 7, a typical aperture spacing is as follows:— 0", 4", 9", 13", 16", 19", 22", 25", 28", 30", 32", 33", 34" (corresponding to spacings measured in metres $\times 10^{-2}$:— 0, 6, 23, 33, 41, 48, 56, 63, 71, 76, 81, 84, 86).

Also, whether fed from one end only, or both ends, the manifolds can be the same diameter for the full length, for example 12 mm inside diameter and 14 mm external diameter, also illustrated in Figure 8.

Circular holes for the apertures 35 are generally the most convenient to form and less affected by any variation in tube diameter and thickness than other forms of aperture.

In the conventional system, as stated previously, there is a variation in the growth rate and thickness of coating, along the length of the holder. This can be as much as $\pm 10\%$ from the specification. By varying the spacing of the apertures 35, the flow of gases into the boats can be controlled and the variations reduced to $\pm 3\%$. A very large advantage obtained from this ability to controlling the gas flow is that the flow rates can be increased considerably, with associated increase in growth rate, without any unacceptable increase in growth non-uniformity across a wafer. Thus, as an example, in the conventional system, with a growth rate of about $2 \times 10^{-8}$ m/min, the

variation is the above mentioned ±10% while with the present invention the variation is about ±3%. At higher flow rates and higher growth rates, the variation in the conventional system rises rapidly, up to ±30% or more. With the present invention with a growth rate of about $4.2 \times 10^{-8}$m per minute, variations of about ±4% are obtained.

A typical process is as follows. Eight boats are loaded with wafers. Generally two wafers are loaded into the boats in pairs, back-to-back, in alternate slots 14 and 15. This will produce a layer or coat on one side of each wafer. Alternately if single wafers are loaded then they will have layers or coatings grown on both sides. After loading the boats they are positioned on the tubes 20. In one configuration, the covers 25 are positioned on the boats and the assembly pushed into the furnace tube. This positioning in the furnace tube is conventional. The manifolds 21 normally remain positioned in the furnace tube, connected to gas supplies. In the alternative configuration, the liner is positioned in the furnace tube and the manifolds inserted and then liner and manifolds normally remain in the furnace, removed only for cleaning. After loading of the boats they are positioned on the tubes 20 and the assembly then pushed into the liner.

A mixture of silane and phosphine, $SiH_4 + PH_3$, is fed to one or both ends of one manifold and oxygen is fed to one or both ends of the other tube. The silane is pure, and the phosphine, in a typical example, is 22-1/2% of the gas, the remainder (77-1/2%) being nitrogen, that is the phosphine supply is a mixture of phosphine and nitrogen. The ratio of silane and phosphine determines, the amount of phosphorus in the oxide layer and the ratio is not critical to the invention. The layer may have from 0 to 10% phosphorus, depending upon requirements.

In the production of the oxide layer, the wafers are cleaned prior to loading, and then after insertion in the furnace, the furnace is purge evacuated, the evacuation kept up for a short time. Then oxygen is admitted, for about 25 minutes, then the silane/phosphine gases are admitted, for about 35 minutes. Then there is purging and then removal. The temperature of the furnace is about 410°C. Typical flow rates are, oxygen 117 cc/minute at 40 psi (2.76 bar), $SiH_4$ 90 cc/minute at 15 psi (1.03 bar), $PH_3$ (22-1/2%) 40 cc/minute at 15 psi (1.03 bar).

The invention enables wafers having a high level of consistency to be produced. By using eight boats, for example, which gives an overall length in excess of the conventional 29" (737 mm), more useful wafers are produced. The end wafers are not usually acceptable and the excess length of the boats provides spare wafers which assist in producing consistent results for the full "flat length" of the furnace. While the covers 25 are shown as solid, slots may be cut in the covers, similar to slots 16 in the boats. The boats are sturdy, cheaper to make and less liable to breakage. The manifolds are cheaper to make and also less fragile. The arrangement of apertures 35 provides even flow of gases. The actual spacing and relative positioning can be varied to provide consistent conditions. While the dimensions given above have produced good results in the exemplified process, the spacing can be varied and desirable spacing can readily be determined by plotting the oxide layer thickness along the line of boats. The spacing of the slots 14 and 15 can also be varied. The spacing of the slots 14 and 15 affects the thickness, that is the growth rate, and also the uniformity. Too close a spacing will cause lack of uniformity across a wafer.

Additional boats can be used, with wafers therein, to create a baffle effect. The excess gases flow out of the ends of the end boats and the extra wafers also help to reduce coating on the apparatus, and reduces the amount of cleaning of the furnace tube necessary.

While, as explained, the invention has been described in relation to the treatment of wafers of 100 mm diameter, the invention is equally applicable to wafers of other sizes. For wafers of other sizes, the dimensions of the boats, manifolds and other structures may vary and also the gas flows will vary. The drawings are illustrative only and are not to scale.

The invention can also be used to form other coatings on wafers, for example polycrystalline silicon.

A sequence of coatings, or layers, can be produced. The invention is applicable to any process in which wafers are mounted in boats and exposed to gas flows in a furnace, in the conventional manner originally described. In some forms of apparatus, and processes, it can be that a gas, or mixture of gases, is supplied by one manifold only, the manifold being in accordance with the manifold of the present invention.

**Claims**

1. Apparatus for producing coatings on semiconductor wafers, comprising:
   a boat (10) for carrying said wafers, said boat comprising:
   an elongated, transversely curved bottom member;
   means (13) for supporting wafers in said bottom member, and
   openings (16) formed in said bottom member to enable gases to flow into said bottom member; and
   a manifold positioned below said bottom member, said manifold comprising an elongated glass tube (21) having at least one inlet for receiving gases for coating said semiconductor wafers, a plurality of circular apertures (35) which are equal in size and in a top surface of said tube, said apertures being spaced from one another along the length of said tube, said spacing being varied in a predetermined manner.

2. An apparatus as claimed in claim 1, wherein said manifold has a gas inlet end to receive gas and has a number of portions of said tube (21) along which said spacing of the apertures (35) decreases along said tube from said gas inlet end.

3. An apparatus as claimed in claim 2, wherein said manifold has two opposite gas inlet ends and has a number of portions of said tube (21) along which said spacing of the apertures (35) decreases along said tube (21) from said gas inlet ends to a position between said gas inlet ends.

4. An apparatus as claimed in claim 1, 2 or 3 including a second manifold similar to said first mentioned manifold, said manifolds being parallel and spaced from each other.

5. An apparatus as claimed in claim 4 including means for supplying gases to each manifold.

6. A process for the production of coatings on semiconductor wafers, including mounting the wafers in boats and supporting the boats in a furnace; feeding a gas to at least one manifold extending beneath the boats; feeding gas from the manifold through aperture means disposed along the manifold, characterised by the aperture means comprising a plurality of spaced circular apertures which are equal in size, the spacing of the apertures (35) being varied in a predetermined manner, the gas flowing up through the boats (10).

7. A process as claimed in claim 6, characterised by feeding gases to two parallel manifolds (21) extending beneath the boats (10).

8. A process as claimed in claim 7, characterised by feeding oxygen to one of the manifolds (21) and a gas containing silane to the other manifold (21).

9. A process as claimed in claim 7, characterised by feeding oxygen to one of the manifolds (21) and a gas containing silane and phosphine to the other manifold (21).

10. A process as claimed in claim 6, 7, 8 or 9, characterised by feeding the gases to only one end of each manifold (21).

**Patentansprüche**

1. Vorrichtung zum Erzeugen von Beschichtungen an Halbleiter-Wafern, mit:

einem Schiffchen (10) zur Aufnahme der Wafer, welches Schiffchen umfaßt:

ein längliches in Querrichtung gekrümmtes Bodenteil;

Mittel (13) zum Abstützen von Wafern in dem Bodenteil, und

in dem Bodenteil ausgeformte Öffnungen (16), um es Gasen zu erlauben, in das Bodenteil zu strömen; und

einen unter dem Bodenteil angeordneten Verteiler, wobei der Verteiler ein längliches Glasrohr (21) mit mindestens einem Einlaß zur Aufnahme von Gasen zum Beschichten der Halbleiter-Wafer besitzt, eine Vielzahl von kreisförmigen Durchbrüchen (35), die mit gleicher Größe in einer oberen Fläche des Rohres vorhanden sind, wobei die Durchbrüche voneinander in Längsrichtung des Rohres Abstände aufweisen, die sich in vorbestimmter Weise ändern.

2. Vorrichtung nach Anspruch 1, bei der der Verteiler ein Gaseinlaßende zum Aufnehmen von Gas besitzt und eine Anzahl von Abschnitten des Rohres (21), längs welchen die Abstände der Durchbrüche (35) in Längsrichtung des Rohres von dem Gaseinlaßende abnehmen.

3. Vorrichtung nach Anspruch 2, bei der der Verteiler zwei einander entgegengesetzt liegende Gaseinlaßenden besitzt und eine Anzahl von Abschnitten des Rohres (21), längs welchen die Abstände der Durchbrüche (35) in Längsrichtung des Rohres (21) von den Gaseinlaßenden bis zu einer Stelle zwischen den Gaseinlaßenden abnehmen.

4. Vorrichtung nach Anspruch 1, 2 oder 3 mit einem zweiten, zum ersterwähnten Verteiler gleichartigen Verteiler, wobei die Verteiler parallel mit Abstand voneinander angeordnet sind.

5. Vorrichtung nach Anspruch 4 mit Mitteln zum Zuführen von Gasen zu jedem Verteiler.

6. Verfahren zur Erzeugung von Beschichtungen an Halbleiter-Wafern, bei dem die Wafer in Schiffchen angebracht und die Schiffchen in einem Ofen abgestützt werden; ein Gas zu mindestens einem sich unterhalb der Schiffchen erstreckenden Verteiler zugeführt wird; Gas von dem Verteiler durch in Längsrichtung des Verteilers angeordnete Durchbruchmittel zugeführt wird, dadurch gekennzeichnet, daß die Durchbruchmittel eine Vielzahl von mit Abstand voneinander versehenen kreisförmigen Durchbrüchen umfassen, die gleich groß sind, wobei der Abstand der Durchbrüche (35) in einer vorbestimmten Weise geändert ist und das Gas durch die Schiffchen (10) nach oben strömt.

7. Verfahren nach Anspruch 6, dadurch gekennzeichnet, daß Gase zu zwei parallelen, sich unterhalb der Schiffchen (10) erstreckenden Verteilern (21) zugeführt werden.

8. Verfahren nach Anspruch 7, dadurch gekennzeichnet, daß dem einem Verteiler (21) Sauerstoff und dem anderen Verteiler (21) ein Silan enthaltendes Gas zugeführt wird.

9. Verfahren nach Anspruch 7, dadurch gekennzeichnet, daß einem der Verteiler (21) Sauerstoff und dem anderen Verteiler (21) ein Silan und Phosphin enthaltendes Gas zugeführt wird.

10. Verfahren nach Anspruch 6, 7, 8 oder 9, dadurch gekennzeichnet, daß die Gase nur einem Ende jedes Verteilers (21) zugeführt werden.

**Revendications**

1. Dispositif pour produire des revêtements sur des plaquettes à semi-conducteur, comprenant:

—une coupelle (10) pour supporter les plaquettes, la coupelle comprenant:

—un élément inférieur allongé, incurvé dans le sens transversal;

—un moyen (13) pour supporter les plaquettes dans l'élément inférieur; et

—des ouvertures (16) ménagées dans l'élément inférieur pour permettre l'entrée de gaz dans l'élément inférieur; et

—un collecteur placé au-dessous de l'élément inférieur, le collecteur comprenant un tube

allongé en verre (21) ayant au moins un orifice d'entrée pour recevoir des gaz pour revêtir les plaquettes à semi-conducteur, une multitude d'ouvertures circulaires (35) de mêmes dimensions ménagées dans la surface supérieure du tube, les ouvertures étant espacées les unes des autres sur la longueur du tube, l'espacement variant d'une manière prédéterminée.

2. Dispositif selon la revendication 1, dans lequel le collecteur a une extrémité d'entrée des gaz pour recevoir des gaz et un certain nombre de parties du tube (21) dans lesquelles l'espacement des ouvertures (35) diminue le long du tube à partir du côté d'entrée des gaz.

3. Dispositif selon la revendication 2, dans lequel le collecteur comporte deux côtés opposés d'entrée des gaz et un certain nombre de parties du tube (21) dans lesquelles l'espacement des ouvertures (35) diminue le long du tube (21) entre les côtés d'entrée des gaz et une position située entre les côtés d'entrée des gaz.

4. Dispositif selon la revendication 1, 2 ou 3, comprenant un second collecteur semblable au premier collecteur mentionné, les collecteurs étant parallèles et espacés l'un de l'autre.

5. Dispositif selon la revendication 4, comprenant un moyen pour fournir des gaz à chaque collecteur.

6. Procédé pour la production de revêtements sur des plaquettes à semi-conducteur, comprenant les étapes consistant à monter les plaquettes dans des coupelles et à supporter les coupelles dans un four; à introduire un gaz dans au moins un collecteur s'étendant au-dessous des coupelles; à introduire du gaz à partir du collecteur par un moyen d'ouverture disposé le long du collecteur, caractérisé en ce que le moyen d'ouverture comprend une multitude d'ouvertures circulaires espacées les unes des autres qui ont des dimensions identiques, l'espacement des ouvertures (35) étant modifié d'une manière prédéterminée, le gaz s'élevant en passant par des coupelles (10).

7. Procédé selon la revendication 6, caractérisé par l'introduction de gaz dans deux collecteurs parallèles (21) s'étendant au-dessous des coupelles (10).

8. Procédé selon la revendication 7, caractérisé par l'introduction d'oxygène dans l'un des collecteurs (21) et d'un gaz contenant du silane dans l'autre collecteur (21).

9. Procédé selon la revendication 7, caractérisé par l'introduction d'oxygène dans l'un des collecteurs (21) et d'un gaz contenant du silane et de la phosphine dans l'autre collecteur (21).

10. Procédé selon la revendication 6, 7, 8 ou 9, caractérisé par l'introduction des gaz dans seulement une extrémité de chaque collecteur (21).

FIG.1.

FIG.2.

FIG.3.

FIG.4.

EP 0 181 624 B1

*FIG.5.*

25
12
26
26
11
26
10
20
28
20
29 29
17 21 13 21 17

*FIG.6.*

28
30
11
12
10
20
20
20
29 29
21 21

*FIG. 7.*

36
21
35 35
35
35
35
31

*FIG. 8.*

37
35
21
35
35
35